Europäisches Patentamt

(19) European Patent Office

Office européen des brevets

(11) Numéro de publication: **0 310 524**
**A1**

(12) **DEMANDE DE BREVET EUROPEEN**

(21) Numéro de dépôt: **88420314.2**

(22) Date de dépôt: **19.09.88**

(51) Int. Cl.⁴: **G 06 J 1/00**
**H 03 M 1/78**

(30) Priorité: **21.09.87 FR 8713331**

(43) Date de publication de la demande:
**05.04.89 Bulletin 89/14**

(84) Etats contractants désignés:
**DE FR GB IT NL SE**

(71) Demandeur: **SGS-THOMSON MICROELECTRONICS S.A.**
**7, Avenue Galliéni**
**F-94250 Gentilly (FR)**

(72) Inventeur: **Ramet, Serge**
**7 Bis, Rue Gabriel Péri**
**F-38000 Grenoble (FR)**

(74) Mandataire: **de Beaumont, Michel et al**
**1bis Rue Champollion**
**F-38000 Grenoble (FR)**

(54) Convertisseur numérique/analogique de sommes pondérées de mots binaires.

(57) La présente invention concerne un convertisseur numérique/analogique pour convertir en une valeur analogique la somme pondérée de valeurs binaires (X, Y) comprenant : un ensemble de cellules identiques, chaque cellule correspondant à des bits de même rang de chaque valeur binaire, chaque cellule comprenant entre une source de tension haute (VCC) et une source de tension basse (M) une résistance série (20) dont la deuxième borne (21) est reliée à une pluralité de sources de courant commutables, chaque source de courant ayant une valeur (I, J) correspondant à la pondération (A, B) de la valeur binaire (X, Y) correspondante, la résistance série de la cellule du bit le moins significatif ayant une valeur R, la résistance série de la cellule du bit le plus significatif ayant une valeur quelconque non nulle ($R_L$), la résistance série des autres cellules ayant une valeur 2R ; des résistances de valeurs R reliant entre elles lesdites deuxièmes bornes des diverses cellules ; et des moyens de sortie aux bornes de ladite résistance série de la cellule du bit le plus significatif.

Figure 4

**Description**

## CONVERTISSEUR NUMÉRIQUE/ANALOGIQUE DE SOMMES PONDÉRÉES DE MOTS BINAIRES

La présente invention concerne un convertisseur numérique/analogique de sommes pondérées de mots binaires. En d'autres termes, étant donné une première série de mots numériques d'entrée A, B, C... et une seconde série de mots numériques d'entrée X, Y, Z... la présente invention concerne un convertisseur numérique/analogique fournissant sous forme analogique le produit scalaire AX + BY + CZ...

Pour simplifier la présente description, on considérera le cas où l'on cherche à obtenir un produit scalaire AX + BY, étant entendu que des produits scalaires à plus grand nombre de termes pourraient être réalisés.

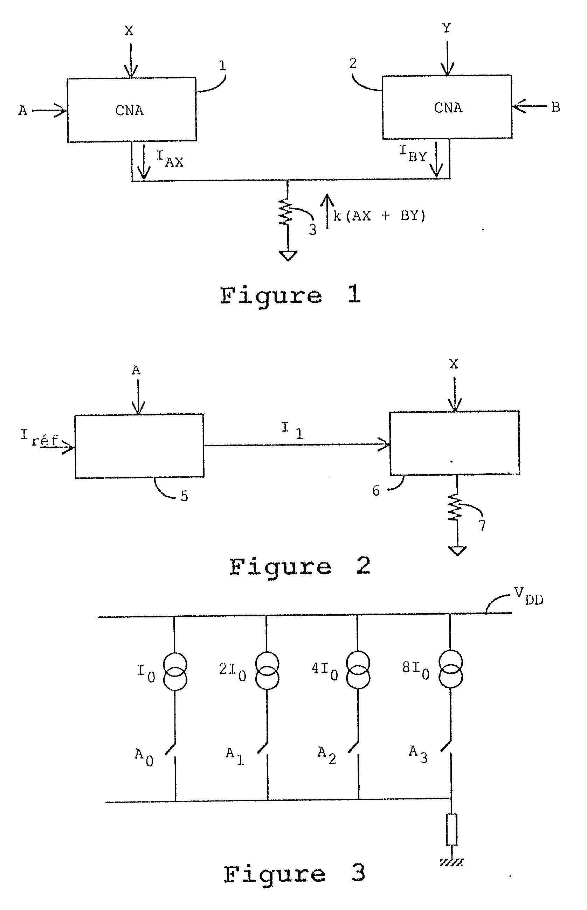

La figure 1 représente le schéma le plus simple de formation d'un tel produit scalaire. Les données numériques X et A sont introduites dans un premier convertisseur analogique/numérique 1 qui fournit en sortie un courant $I_{AX}$ égal au produit AX multiplié par un facteur de proportionnalité k ($I_{AX} = kAX$). De même, un deuxième convertisseur numérique/analogique 2 recevant les valeurs ou mots numériques Y et B fournit un courant $I_{BY}$ et l'on prélève à la sortie des convertisseurs 1 et 2, sur une résistance 3, un signal proportionnel à AX + BY.

Un convertisseur numérique/analogique à multiplication tel que ceux désignés par les références 1 et 2 en figure 1 est typiquement réalisé de la façon illustrée en figure 2. Un premier convertisseur numérique/analogique 5 reçoit l'entrée A et un courant de référence $I_{ref}$ et applique sa sortie $I_1$ comme entrée de référence à un deuxième convertisseur numérique/analogique 6 recevant l'entrée X et fournissant aux bornes d'une résistance de sortie 7 une tension proportionnelle au produit AX.

La figure 3 représente un exemple de convertisseur numérique/analogique classique. Celui-ci comprend entre une tension haute VDD et une tension basse M que l'on prendra égale à la masse des sources de courant de valeurs respectives $I_0$, $2I_0$, $4I_0$, $8I_0$,.... Chacune de ces sources est en série avec un interrupteur respectif A0, A1, A2, A3... correspondant aux bits de rangs successifs d'un mot A à transformer en valeur analogique. En conséquence, le courant qui sera extrait de la source de tension VDD par les sources de courant $I_0$, $2I_0$, $4I_0$, $8I_0$... dépendra des valeurs des bits successifs du mot à convertir. Ce type de convertisseur numérique/analogique, apparemment très simple, nécessite en fait un grand nombre de composants étant donné que les sources de courant multiples les unes des autres sont en fait réalisées par une multiplicité de transistors identiques traversés par le même courant. De plus, les dispersions existant dans la fabrication des circuits intégrés entraînent qu'un tel convertisseur peut difficilement être utilisé pour des conversions de mots de plus de 7 bits sans qu'il soit nécessaire de prévoir des ajustages, par exemple des résistances ajustables par laser. En plus de ces défauts, réaliser un produit scalaire avec de tels convertisseurs nécessite d'en utiliser plusieurs comme le montrent les figures 1 et 2.

Un objet de la présente invention est de prévoir un convertisseur adapté à la formation de produits scalaires et plus particulièrement un tel convertisseur qui soit simple à fabriquer, qui utilise un petit nombre de composants, et qui occupe une faible surface lors de sa réalisation sous forme de circuit intégré.

Ainsi, la présente invention prévoit un convertisseur numérique/analogique pour convertir en une valeur analogique la somme pondérée de valeurs binaires comprenant un ensemble de cellules, identiques, chaque cellule correspondant à des bits de même rang de chaque valeur binaire, chaque cellule comprenant entre une source de tension haute et une source de tension basse une résistance série dont la deuxième borne est reliée à une pluralité de sources de courant commutables, chaque source de courant ayant une valeur correspondant à la pondération de la valeur binaire correspondante, la résistance série de la cellule du bit le moins significatif ayant une valeur R, la résistance série de la cellule du bit le plus significatif ayant une valeur quelconque non nulle, la résistance série des autres cellules ayant une valeur 2R ; des résistances de valeurs R reliant entre elles lesdites deuxièmes bornes des diverses cellules ; et des moyens de sortie aux bornes de ladite résistance série de la cellule du bit le plus significatif.

Selon un mode de réalisation de la présente invention, les sources de courant commutables comprennent un interrupteur en série avec une source de courant, et chaque source de courant est en outre reliée, part un deuxième interrupteur recevant un signal complémentaire du premier, directement à la source de tension haute. Les valeurs de pondération pourront elles-mêmes provenir de mots numériques et être converties par des convertisseurs numérique/analogique pour influer sur les sources de courant.

Ces objets, caractéristiques et avantages ainsi que d'autres de la présente invention seront exposés plus en détail dans la description suivante d'un mode de réalisation particulier faite en relation avec les figures jointes parmi lesquelles :

la figure 1 à 3, décrites précédemment, représentent des convertisseurs selon l'art antérieur ;

la figure 4 représente un convertisseur selon la présente invenion ; et

la figure 5 représente un mode de réalisation d'un cellule d'un circuit selon la présente invention.

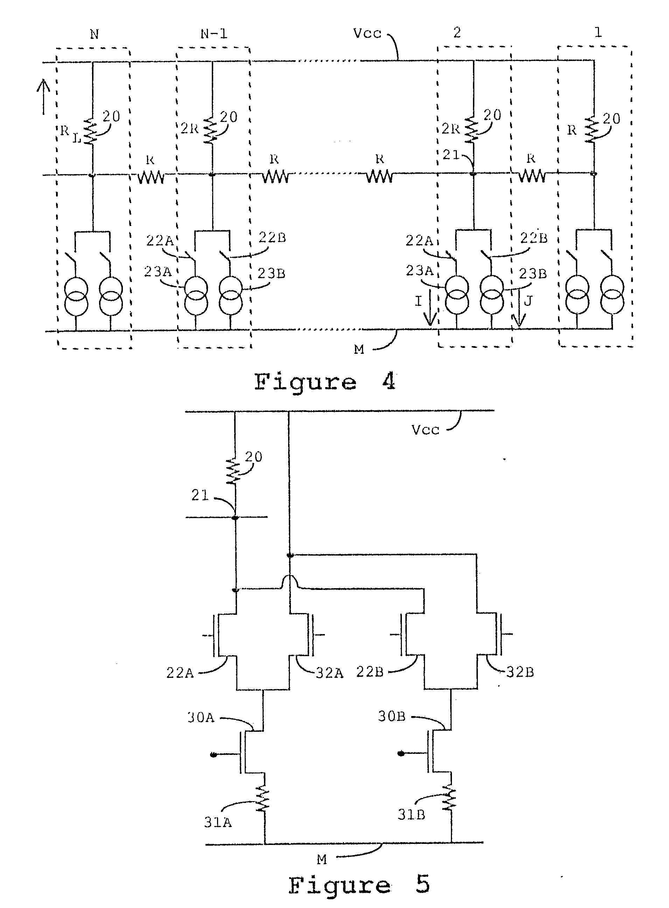

la figure 4 représente un convertisseur selon las présente invention permettant, d'une part, de réaliser avec précision des conversions de mots à nombre de bits important et, d'autre part, de réaliser directement et simplement des produits scalaires en utilisant un nombre de composants élémentaires aussi faible que possible, c'est-à-dire une faible surface de silicium sur le circuit intégré incluant ce convertisseur.

La figure 4 représente schématiquement un convertisseur selon la présente invention muni d'un nombre N de cellules correspondant au nombre N de bits des mots numériques à convertir.

Chaque cellule comprend une résistance 20 reliée, d'une part, à une tension d'alimentation VCC, d'autre part, à un point de connexion 21. A ce point de connexion 21 sont reliées en parallèle des sources de courant commandées, figurées comme comprenant chacune en série un interrupteur 22, respectivement 22A et 22B, et une source de courant 23, respectivement 23A et 23B.Il y a autant de sources de courant, 23A et 23B, en parallèle que de mots numériques X, Y dont on veut faire la somme pondérée. Dans l'exemple de la figure 4, il est prévu seulement deux sources de courant commandées en parallèle. L'autre borne des sources de courant 23 est reliée à une tension de référence telle que la masse M, les tensions VCC et M étant choisies pour permettre un bon fonctionnement des sources de courant.

Des cellules adjacentes sont reliées entre elles par une résistance R allant d'un point de connexion 21 aux points de connexion 21 adjacents. Les couples de sources de courant 23A et 23B de toutes les cellules sont identiques. Toutes les sources de courant 23A délivrent un courant I proportionnel à la valeur A par laquelle on veut multiplier la valeur X et toutes les sources de courant 23B délivrent un courant J proportionnel à la valeur B par laquelle on veut multiplier la valeur Y. Les interrupteurs 22A des diverses cellules sont ouverts ou fermés selon les valeurs des bits de rang correspondant du nombre X et de même les interrupteurs 22B sont ouverts ou fermés selon les valeurs des bits de rang correspondant du nombre Y.

Les résistances 20 ont toutes la valeur 2R pour les cellules intermédiaires, la valeur R pour la cellule 1 corresponddant au bit le moins significatif, et la valeur $R_L$ pour la cellule N correspondant au bit le plus significatif. Le valeur $R_L$ peut être quelconque, non nulle, éventuellement aussi élevée qu'on le souhaite ou même infinie. La valeur analogique recherchée correspondant au produit AX + BY est relevée aux bornes de la résistance $R_L$. Elle s'écrit :

$$V = [2RR_L/(2R + R_L)].[(X5 + X4/2 + X3/4 + X2/8 + X1/16 + X0/32).I + (Y5 + Y4/2 + Y3/4 + Y2/8 + Y1/16 + Y0/32).J],$$

dans le cas où les nombres X et Y à pondérer et à additionner sont des nombres à 6 bits (X0 à X5 et Y0 à Y5).

La figure 5 représente un exemple de réalisation plus détaillé d'une cellule selon la présente invention. On retrouve en figure 5 les sources de tension VCC et M, la résistance 20 et le point de connexion 21. La source de courant 23A de valeur I est réalisée au moyen de la connexion en série d'un transistor MOS à canal N 30A et d'une résistance 31A, le transistor MOS à canal N 30A étant monté en miroir de courant avec un moyen de détermination du courant proportionnel à la valeur A que l'on souhaite obtenir, de même que tous les autres transistors 30A des autres cellules. L'interrupteur 22A est réalisé également sous forme d'un transistor MOS à canal N mais on a ajouté un transistor 32A recevant un signal complémentaire de celui du transistor 22A pour relier la source de courant directement à la tension VCC pour éviter d'interrompre brutalement le courant dans la source de courant lors des commutations. De même, des éléments 22B et 30B à 32B sont prévus pour une deuxième source de courant commutée en parallèle sur la première.

**Revendications**

1. Convertisseur numérique/analogique pour convertir en une valeur analogique la somme pondérée de valeurs binaires (X, Y) caractérisé en ce qu'il comprend :
- un ensemble de cellules identique, chaque cellule correspondant à des bits de même rang de chaque valeur binaire, chaque cellule comprenant entre une source de tension haute (VCC) et une source de tension basse (M) une résistance série (20) dont la deuxième borne (21) est reliée à une pluralité de sources de courant commutables, chaque source de courant ayant une valeur (I, J) correspondant à la pondération (A, B) de la valeur binaire (X, Y) correspondante,
. la résistance série de la cellule du bit le moins significatif ayant une valeur R,
. la résistance série de la cellule du bit le plus significatif ayant une valeur quelconque non nulle ($R_L$),
. la résistance série des autres cellules ayant une valeur 2R ;
- des résistances de valeurs R reliant entre elles lesdites deuxièmes bornes des diverses cellules ; et
- des moyens de sortie aux bornes de ladite résistance série de la cellule du bit le plus significatif.

2. Convertisseur numérique/analogique selon la revendication 1, caractérisé en ce que lesdites sources de courant commutables comprennent un interrupteur (22A, 22B) en série avec une source de courant (23A, 23B).

3. Convertisseur numérique/analogique selon la revendication 2, caractérisé en ce que chaque source de courant est en outre reliée par un deuxième interrupteur (32A, 32B) recevant un signal complémentaire du premier directement à la source de tension haute.

4. Convertisseur numérique/analogique selon l'une quelconque des revendications 1 à 3, caractérisé en ce que les valeurs de pondération proviennent elles-mêmes de mots numériques (A, B) et sont converties par des convertisseurs numérique/analogique pour influer sur les sources de courant.

Figure 1

Figure 2

Figure 3

Figure 4

Figure 5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | US-A-4 168 528 (COMER)<br>* Colonne 2, ligne 54 - colonne 3, ligne 13; figure 1; colonne 3, ligne 54 - colonne 4, ligne 3; figure 2; colonne 6, lignes 50-65 *<br>--- | 1,2,4 | G 06 J 1/00<br>H 03 M 1/78 |
| Y | US-A-3 857 021 (WILENSKY)<br>* Colonne 1, lignes 46-52; colonne 2, ligne 15 - colonne 3, ligne 2; colonne 4, lignes 45-56; figures 1,2 *<br>--- | 1,2,4 | |
| Y | US-A-3 504 360 (VOSBURY)<br>* Colonne 3, lignes 5-69; figure 1 *<br>--- | 1,2,4 | |
| A | DE-C-3 529 338 (DENSHI)<br>* En entier *<br>--- | 1 | |
| A | US-A-3 183 342 (WORTZMAN)<br>* Colonne 5, ligne 70 - colonne 6, ligne 16; figure 8 *<br>----- | 1 | |

DOMAINES TECHNIQUES RECHERCHES (Int. Cl.4)

G 06 J 1/00
H 03 M 1/78

Le présent rapport a été établi pour toutes les revendications

| Lieu de la recherche | Date d'achèvement de la recherche | Examinateur |
|---|---|---|
| LA HAYE | 09-12-1988 | GUIVOL Y. |

EPO FORM 1503 03.82 (P0402)